(19) Europäisches Patentamt
European Patent Office
Office européen des brevets

(11) Publication number: **0 043 132**
**B2**

(12) # NEW EUROPEAN PATENT SPECIFICATION

(45) Date of publication of the new patent specification: **08.02.89**

(51) Int. Cl.⁴: **G 03 F 7/02**

(21) Application number: **81105035.0**

(22) Date of filing: **29.06.81**

(54) **A developer for dry planographic printing plates.**

(30) Priority: **30.06.80 JP 87795/80**

(43) Date of publication of application: **06.01.82 Bulletin 82/01**

(45) Publication of the grant of the patent: **02.01.85 Bulletin 85/01**

(45) Mention of the opposition decision: **08.02.89 Bulletin 89/06**

(84) Designated Contracting States: **CH DE FR GB IT LI NL**

(56) References cited:
US-A-3 677 178
US-A-3 894 873
US-A-3 953 212

(73) Proprietor: **TORAY INDUSTRIES, INC.**
**2, Nihonbashi-Muromachi 2-chome Chuo-ku**
**Tokyo 103 (JP)**

(72) Inventor: **Suezawa, Mitsuru**
**No. 5, 2-chome Sonoyama**
**Ohtsu-shi Shiga-ken (JP)**
Inventor: **Asano, Masaya**
**No. 10, 2-chome Sonoyama**
**Ohtsu-shi Shiga-ken (JP)**

(74) Representative: **Kador & Partner**
**Corneliusstrasse 15**
**D-8000 München 5 (DE)**

**The file contains technical information submitted after the application was filed and not included in this specification**

**EP 0 043 132 B2**

**Description**

The present invention relates to a developer for a dry planographic printing plate on paraffin hydrocarbons basis.

Various structures have already been proposed for a dry planographic printing plate having a silicone rubber layer which is an ink-repellent non-image area. The dry planographic printing plates disclosed, for example, in Japanese Patent no. 1 030 979 or the Japanese Laid Open Patent Application No. 50—50102, are each composed of a silicone rubber layer overlying a photoadhesive layer on a base substrate, and capable of printing tens of thousands of sheets without use of a dampening solution.

The dry planographic printing plates as described above are normally processed by exposure to light and developing.

First of all, an unprocessed plate is exposed to actinic radiation through a positive-film which is brought into vacuum contact with the plate. The exposed plate is then immersed in a developer of paraffin hydrocarbon or a developer mainly composed thereof, as a result of which the silicone rubber layer in the unexposed areas is extremely swollen and crumpled or resembles a washboard. In this state, when the surface of the printing plate is rubbed lightly with a soft pad of gauze or the like, the silicone rubber layer in the unexposed areas is rubbed off selectively, thus baring an unhardened photoadhesive underlayer which becomes an ink-receptive image area. On the other hand, the silicon rubber layer in the exposed area, although slightly swollen by the developer, still adheres or binds firmly to the photopolymerized photoadhesive layer, and therefore remains on the plate surface without being affected even by strong rubbing with the developer pad, and since this portion forms an ink-repellent non-image area, the dry planographic printing plate is produced. The dry planographic printing plate obtained by the processes described above has high resolving power. However, in the case of insufficient developing, for example, the silicone rubber layer should normally have been broken off from the photoadhesive layer, thus resulting in a printing plate with poor resolving power. If the plate surface is too strongly rubbed during the developing, even if the silicone rubber layer which should be left on the printing plate surface as a non-image area is impaired, which gives rise to toning and pin holes or defects in the printed matter finally produced, so that one is faced with the problem that a printing plate with excellent printability cannot be obtained.

It has now been found that, by the addition of a propylene oxide derivative to the developer used in the developing process of the dry planographic printing plate having a silicone rubber layer as the ink-repellent non-image area, a marked improvement in the developing characteristics is obtained, so that a printing plate with excellent dot reproducibility emerges.

The developer according to the present invention is characterized by that it contains at least 0.1% by weight, but preferably 2 to 20% by weight of a propylene oxide derivative represented by the following general formula:

$$RO\!\left(CH_2-\overset{\overset{\displaystyle CH_3}{|}}{C}H-O\right)_{n}R' \qquad RO\!\left(CH_2-\overset{\overset{\displaystyle CH_3}{|}}{C}H-O\right)_{p}\!\left(CH_2-CH_2-O\right)_{m}R'$$

whereby R and R′ are identical or different radicals selected from the group consisting of hydrogen, substituted or unsubstituted alkyl groups having 1 to 20 carbon atoms, substituted or unsubstituted aryl or aralkyl groups having 6 to 20 carbon atoms and substituted or unsubstituted acyl groups having 1 to 20 carbon atoms, n is an integer from 2 to 50, p is an integer from 1 to 50, m is an integer from 1 to 25, and m is most one half of p, and R includes multivalent radicals with up to 8 valencies.

Generally, solvents used as a developer for the dry planographic printing plate having a silicone rubber layer which is the ink-repellent non-image area, have the characteristic of causing the silicone rubber to swell, and solvents composed of paraffin hydrocarbon or mainly thereof are commonly used. Such solvents as these are readily available from the fractional distillation products of petroleum. In addition to these fractional distillation products of petroleum, refined paraffin hydrocarbons such as pentane, hexane, heptane, octane, etc. may of course be employed as useful solvents.

Furthermore, solutions may be used which are prepared by adding to the above solvents, water, alcohols such as cyclohexanol, n-octyl alcohol, n-decyl alcohol, lauryl alcohol, 3-methyl-3-methoxybutanol, benzyl alcohol, 2,3,5-trimethyl hexanol, etc., esters such as diethylene glycol diacetate, diethylene glycol butylether acetate, diethylene glycol ethylether acetate, dibutyl adipate, dibutyl sebacate, diethyl sebacate, dibutyl phthalate, diethyl succinate, etc., ethers such as butyl ether, ethyl hexyl ether, diethylene glycol monoethyl ether, diethylene glycol monobutyl ether, triethylene glycol monomethyl ether, triethylene glycol dimethyl ether, etc., and carboxylic acids such as 2-ethylhexanoic acid, oleic acid, dimer acid, ricinoleic acid, etc., aromatic hydrocarbons, alicyclic hydrocarbons, halogenated hydrocarbons, etc., to an extent so as practically not to dissolve even the unhardened photoadhesive layer. Further examples are emulsions of the foregoing substances using suitable emulsifying agents. Dyes may also be added.

The developer of the present invention may be prepared by adding at least one kind of propylene oxide derivative to the solvents or mixed solutions for the developer as described above in the amount of at last

0.1%, but preferably in an amount of 2 to 20% by weight. The propylene oxide derivatives referred to above comprise compounds available by an addition reaction of propylene oxide, which are represented by the following general formula:

$$RO\!\left(CH_2-\underset{}{\overset{CH_3}{\overset{|}{C}}}H-O\right)_{n}R' \qquad RO\!\left(CH_2-\overset{CH_3}{\overset{|}{C}}H-O\right)_{p}\!\left(CH_2-CH_2-O\right)_{m}R'$$

whereby R and R′ are identical or different radicals selected from the group consisting of hydrogen, substituted or unsubstituted alkyl groups having 1 to 20 carbon atoms, but preferably 1 to 5 carbon atoms, substituted or unsubstituted aryl groups or aralkyl groups with 6 to 20 carbon atoms, and substituted or unsubstituted acyl groups with 1 to 20 carbon atoms, but preferably 1 to 5 carbon atoms, n is an integer from 2 to 50, but preferably 1 to 20, p is an integer from 1 to 50, m is an integer from 1 to 25, and m is at most one half of p. The above-mentioned groups may be substituted by various substituents, especially halogen atoms, hydroxyl groups, etc., to an extent so as not to affect the plate material adversely. R includes multivalent radicals with up to 8 valencies.

As specific examples of propylene oxide derivatives which may be employed, the following may be cited: glycol, dipropylene glycol, tripropylene glycol, polypropylene glycol, propylene oxide-ethylene oxide copolymers, monovalent alcohol (for example, methanol, propanol, butanol, etc.)-propylene oxide addition products, monovalent alcohol-propylene oxide-ethylene oxide addition products, polyvalent alcohol (for example, glycerin, trimethylolpropane, etc.)-propylene oxide addition products, carboxylic acid-propylene oxide addition products, alkylphenol-propylene oxide addition products, etc.

Of the above substances, polypropylene glycol having an average molecular weight in the range of 100 to 2000, but preferably 150 to 600, dipropylene glycol monomethyl ether, tripropylene glycol monomethyl ether, dipropylene monobutyl ether, tripropylene glycol monobutyl ether, propylene oxide-ethylene oxide copolymers having an average molecular weight in the range of 150 to 2000 and monobutyl ether thereof are particularly useful.

The dry planographic printing plate which is suitable for the present invention is a dry planographic printing plate having a silicone rubber layer, which is an ink-repellent non-image area, but preferably a positive-working dry planographic printing plate having a silicone rubber layer overlying a photoadhesive layer on a base substrate.

Hereinbelow, said positive-working dry planographic printing plate will be described.

The base substrate for the planographic printing plate should be sufficiently flexible so that it can be mounted on a lithographic press, and strong enough to withstand the stress normally produced by the lithographic printing process. For the representative base substrates, coated paper, metallic plates or plastic films such as polyethylene terephthalate, etc. may be used. It is useful to provide a layer to prevent halation on such base substrates.

The photoadhesive layer has the characteristics of polymerizing and binding the overlying silicone rubber layer when exposed to actinic radiation.

The thickness of the photoadhesive layer may be selected as desired, provided that said layer is uniformly applied to the base substrate so as to adhere closely thereto, but it should preferably be less than $1 \times 10^{-2}$ cm, and a thickness less than $5 \times 10^{-3}$ cm is more suited to the purpose at hand.

If required, it may also be useful to provide an anchor coating layer between the base substrate and the photoadhesive layer to improve the adhesiveness or prevent undesirable halation.

The photoadhesive layer as described above may be provided with the compositions shown in the following:

1. At least one kind of photopolymerizable unsaturated monomer or oligomer having a boiling point above 100°C — 1.0 to 99.9 parts by weight
2. A photoinitiator — 0.1 to 20.0 parts by weight
3. A heat polymerization inhibitor, if required — 0.01 to 10 parts by weight
4. A polymer or inorganic powder as a filler to maintain the dimensional stability of the photoadhesive layer, if required — 0.01 to 95.0 parts by weight.

Representative examples of the photopolymerizable monomer or oligomer are (meth)acrylic ester or (meth)acrylamide having a boiling point above 100°C and derived from monovalent alcohol or monovalent amine with a carbon number less than 30, and (meth)acrylic ester or (meth)acrylamide having a boiling point above 100°C and derived from polyvalent alcohol or polyvalent amine having a carbon number less than 80.

Representative examples of the photoinitiator include benzophenone, xanthone, benzoin methyl ether, dibenzyl disulfide, uranyl nitrate, etc., while representative examples of the heat polymerization inhibitor include hydroquinone, phenothiazine, 2,4-dinitrophenol, triphenyl methane, etc. Moreover, for the filler, polymers such as poly(meth)acrylic ester, polyurethane, polyamide, polyester, etc., and inorganic powders such as coloidal silica, calcium carbonate, etc. are useful.

The silicone rubber layer has a thickness in the range of $5 \times 10^{-5}$ cm to $5 \times 10^{-3}$ cm, but preferably in the range of $5 \times 10^{-5}$ cm to $5 \times 10^{-4}$ cm, and transparency allowing actinic radiation to pass therethrough. Silicone rubbers suitable for use are linear diorganopolysiloxanes (preferably dimethyl polysiloxanes) having a molecular weight of 100 to 100,000 which are crosslinked by the condensation of the end groups, with crosslining agents and catalysts being added thereto as required. The silicone rubber layer has ink-repellency, while the surface thereof is somewhat tacky and very subject to adhesion of dust and dirt, thus tending to involve problems such as insufficiently close contact to the positive film in the exposing process. Therefore a thin transparent protective film may be applied to the surface of the silicone rubber layer. This protective film also plays a part in suppressing the penetration of oxygen from the air into the photoadhesive layer so as to promote the photopolymerization. As described above, although the protective film is useful in the exposing process, it is of course removed for the developing process by being peeled off or dissolved, and is not required in the printing process. Useful protective films have a transparency permitting actinic radiation to pass therethrough and a thickness less than $1 \times 10^{-3}$ cm, but preferably less than $1 \times 10^{-3}$ cm, and representative examples of such protective films include plastic films such as polyethylene, polypropylene, polyvinyl chloride, polyvinylidene chloride, polyvinyl alcohol, polyethylene terephthalate, cellophane, etc.

When the unprocessed plate for the dry planographic printing is prepared in this way, the positive film is subjected to close contact by use of an ordinary vacuum frame for the planographic printing plate, and the actinic radiation is projected thereonto through said film. After removal of the protective film, is used, the exposed plate is developed.

Then the silicone rubber layer in the image area is rubbed off selectively by lightly rubbing the plate surface with a soft pad of non-woven fabric or the like, and thus the photoadhesive layer in the image areas can be bared. If necessary, the image areas may then be dyed according to the method disclosed in the Japanese Laid Open Patent Application No. 54—103103.

By applying the developer according to the present invention it is possible to obtain a printing plate having excellent resolving power and less scratches and faults, in a developing period shorter than that of conventional methods.

Hereinbelow, examples are provided to illustrate the present invention further, without, however, limiting the scope thereof.

## Examples

On the base substrates of aluminum, photoadhesive layers of $4 \times 10^{-4}$ cm in thickness, having the following compositions, were provided.

(a) Polyurethane of polyester polyol of adipic acid and hexane-1,6-diol, 2,2-dimethyl propane-1,3-diol, and isophorone di-isocyanate — 56 parts by weight
(b) Addition product of 4 mols of glycidyl methacrylate with 1 mol of xylylene diamine — 40 parts by weight
(c) Michler's ketone — 4 parts by weight

The surface of the photoadhesive layer was coated with a 10% n-hexane solution of the following silicone gum composition to provide a silicone rubber layer $3 \times 10^{-4}$ cm thick after drying and curing at 50°C.

(a) Dimethylpolysiloxane (molecular weight about 80,000) — 100 parts by weight
(b) Methyltriacetoxysilane — 5 parts by weight
(c) Dibutyl tin diacetate — 0.2 parts by weight

On the plate prepared in the above manner, polyethylene terephthalate film "Luminar" (manufactured by Toray Industries Inc.) in a thickness of $1 \times 10^{-3}$ cm was laminated as a protective film so as to provide the unprocessed dry planographic printing plate.

Subsequently, a positive film with the percentage of dots altered by steps (2% to 98%, 200 lines per 2.54 cm) was brought into close contact with said unprocessed dry planographic printing plate, and subjected to exposure for 90 seconds to a high pressure mercury lamp (ORC Jet Light 300) from a distance of 1 m.

Thereafter, the protective film of the exposed plate was peeled off, and each of the exposed plates was developed by the developers as shown in Table 1, so as to obtain the dry planographic printing plates. The time required for the development of the printing plates by said developers and the dot reproducibility of the printing plates are set forth in Table 1.

TABLE 1

| No. | Developer Compositions | Weight percentage (%) | Time required to develop the plate of A1 size | Dot reproducibility (200 lines, 2%—98%) |
|---|---|---|---|---|
| 1 | n-Hexane | 100 | 20 min. | 6%—98% |
| 2 | n-Hexane | 98 | | |
| | Polypropylene glycol (average molecular weight 200) | 2 | 5 min. | 2%—98% |
| 3 | n-Hexane | 92 | | |
| | Polypropylene glycol (average molecular weight 400) | 8 | 5 min. | 2%—98% |
| 4 | Polypropylene glycol (average molecular weight 400) | 100 | 10 min. | 2%—98% |
| 5 | n-Hexane | 90 | 5 min. | 2%—98% |
| | Dipropylene glycol monomethyl ether | 10 | | |
| 6 | n-Hexane | 90 | 5 min. | 2%—98% |
| | Tripropylene glycol monomethyl ether | 10 | | |
| 7 | n-Hexane | 90 | 5 min. | 2%—98% |
| | Polypropylene glycol (average molecular weight 400) | 5 | | |
| | Dibutyl adipate | 5 | | |
| 8 | n-Hexane | 85 | 5 min. | 2%—98% |
| | Polypropylene glycol (average molecular weight 400) | 10 | | |
| | 2-, 3-, 5-Trimethyl-hexanol | 5 | | |
| 9 | n-Hexane | 70 | 5 min. | 2%—98% |
| | Polypropylene oxide-ethylene oxide-monostearyl ether (average molecular weight 1600) | 15 | | |
| | Diethylene glycol monobutyl ether | 15 | | |

TABLE 1

| No. | Developer Compositions | Weight percentage (%) | Time required to develop the plate of A1 size | Dot reproducibility (200 lines, 2%—98%) |
|---|---|---|---|---|
| 10 | n-Hexane<br>Propylene oxide addition product of glycerine (average molecular weight 400) | 93<br>7 | 5 min. | 2%—98% |
| 11 | n-Hexane<br>Diethylene glycol monoethyl ether | 95<br>5 | 10 min. | 4%—98% |
| 12 | n-Hexane<br>Diethylene glycol monoethyl ether | 90<br>10 | The photoadhesive layer is dissolved | |

When No. 2 to No. 10 of the developers of the present invention containing the propylene oxide derivative are used, the silicone rubber layer in the image areas can be broken off selectively practically without affecting and dissolving the unhardened photoadhesive layer, the dot reproducibility being in the range of 2 to 98% in each case. For comparison, when the developers No. 1 and No. 11, which do not contain the propylene oxide derivative, are used, not only is the developing time prolonged, but the dot reproducibility is also insufficient, although it is possible to break off the silicone rubber layer in the image areas selectively practically without affecting and dissolving the unhardened photoadhesive layer. Furthermore, in the case of developer No. 12, the photoadhesive layer is dissolved, so that this developer is clearly unsuitable.

**Claims**

1. A developer for a dry planographic printing plate on paraffin hydrocarbons basis containing at least 0.1% by weight, but preferably 2 to 20% by weight of a propylene oxide derivative represented by the following general formula:

$$RO\!\left(CH_2-\underset{\displaystyle |}{\overset{CH_3}{}}\!\!CH-O\right)_{n}R' \quad \text{or} \quad RO\!\left(CH_2-\overset{CH_3}{\underset{}{|}}\!\!CH-O\right)_{p}\!\left(CH_2-CH_2-O\right)_{m}R'$$

whereby R and R′ are identical or different radicals selected from the group consisting of hydrogen, substituted or unsubstituted alkyl groups having 1 to 20 carbon atoms, substituted or unsubstituted aryl or aralkyl groups having 6 to 20 carbon atoms and substituted or unsubstituted acyl groups having 1 to 20 carbon atoms, n is an integer from 2 to 50, p is an integer from 1 to 50, m is an integer from 1 to 25, and m is at most one half of p, and R includes multivalent radicals with up to 8 valencies.

2. A developer as in claim 1 characterized in that the propylene oxide derivative is selected from the group consisting of polypropylene glycol, dipropylene glycol monomethyl ether, tripropylene glycol monomethyl ether, dipropylene glycol monobutyl ether, tripropylene glycol monobutyl ether, propylene oxide-ethylene oxide copolymers and monobutyl ether thereof.

**Patentansprüche**

1. Entwickler für Trockenflachdruckplatte auf der Basis paraffinischer Kohlenwasserstoffe, der zumindest 0,1 Gew-%, vorzugsweise jedoch 2 bis 20 Gew-% eines Propylenoxid-Derivates der folgenden allgemeinen Formel umfaßt:

$$RO\!\left(CH_2-\overset{CH_3}{\underset{}{|}}\!\!CH-O\right)_{n}R' \quad \text{oder} \quad RO\!\left(CH_2-\overset{CH_3}{\underset{}{|}}\!\!CH-O\right)_{p}\!\left(CH_2-CH_2-O\right)_{m}R'$$

worin R und R′ identische oder verschiedene Radikale sind, die aus der Gruppe ausgewählt sind, die aus

Wasserstoff, substituierten oder unsubstituierten Alkylgruppen mit 1 bis 20 Kohlenstoffatomen, substituierten oder unsubstituierten Aryl- oder Aralkylgruppen mit 6 bis 20 Kohlenstoffatomen und substituierten oder unsubstituierten Acylgruppen mit 1 bis 20 Kohlenstoffatomen besteht, n eine ganze Zahl von 2 bis 50 ist, p eine ganze Zahl von 1 bis 50 ist, m eine ganze Zahl von 1 bis 25 ist und m höchstens die Hälfte von p beträgt und R mehrwertige Radikale mit bis zu acht Valenzen umfaßt.

2. Entwickler nach Anspruch 1, dadurch gekennzeichnet, daß das Propylenoxid-Derivat aus der Gruppe ausgewählt ist, die aus Polypropylenglycol, Dipropylenglycolmonomethylether, Tripropylenglycolmonomethylether, Dipropylenglycolmonobutylether, Tripropylenglycolmonobutylether, Propylenoxid-Ethylenoxid-Copolymeren und dem Monobutylether davon besteht.

**Revendications**

1. Révélateur pour une plaque d'impression planographique à sec, composée principalement d'hydrocarbures paraffiniques, contenant au moins 0,1% en poids, mais de préférence 2 à 20% en poids, d'un dérivé d'oxyde de propylene représenté par la formule générale suivante:

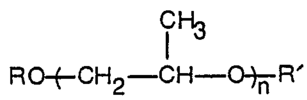
ou
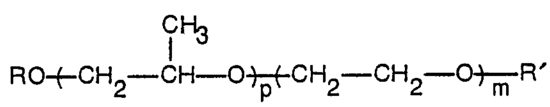

où R et R' sont des radicaux identiques ou différents, choisis dans le groupe se composant de l'hydrogène, de groupes alkyles substitués ou non substitués ayant 1 à 20 atomes de carbone, de groupes aryles ou aralkyles substitués ou non substitués ayant 6 à 20 atomes de carbone et de groupes acyles substitués ou non substitués ayant 1 à 20 atomes de carbone, n est un nombre entier de 2 à 50, p est un nombre entier de 1 à 50, m est un nombre entier de 1 à 25, et m est au plus la moitié de p, et R comprend des radicaux multivalents ayant jusqu'à 8 valences.

2. Révélateur selon la revendication 1, caractérisé en ce que le dérivé d'oxyde de propylène est choisi dans le groupe se composant de polypropylèneglycol, d'éther monométhylique de dipropylèneglycol, d'éther monométhylique de tripropylèneglycol, d'éther monobutylique de dipropylèneglycol, d'éther monobutylique de tripropylèneglycol, de copolymères oxyde de propylène-oxyde d'éthylène et de leur éther monobutylique.